(19) Europäisches Patentamt
European Patent Office
Office européen des brevets

(11) EP 4 379 818 A1

(12) EUROPEAN PATENT APPLICATION
published in accordance with Art. 153(4) EPC

(43) Date of publication:
05.06.2024 Bulletin 2024/23

(21) Application number: 22862754.3

(22) Date of filing: 26.05.2022

(51) International Patent Classification (IPC):
H01L 31/0725 (2012.01)    H01L 31/0216 (2014.01)
H01L 31/0747 (2012.01)    H10K 50/00 (2023.01)

(52) Cooperative Patent Classification (CPC):
H01L 31/0216; H01L 31/0725; H01L 31/0747;
H10K 50/11; Y02E 10/52

(86) International application number:
PCT/CN2022/095202

(87) International publication number:
WO 2023/029612 (09.03.2023 Gazette 2023/10)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 01.09.2021 CN 202111029107

(71) Applicant: Longi Green Energy Technology Co.,
Ltd.
Xi'an, Shaanxi 710100 (CN)

(72) Inventors:
• WU, Zhao
  Xi' an, Shaanxi 710100 (CN)
• XU, Chen
  Xi' an, Shaanxi 710100 (CN)
• LI, Zifeng
  Xi' an, Shaanxi 710100 (CN)
• XIE, Junjie
  Xi' an, Shaanxi 710100 (CN)
• LIU, Tong
  Xi' an, Shaanxi 710100 (CN)

(74) Representative: Loo, Chi Ching et al
Albright IP Limited
County House
Bayshill Road
Cheltenham, Gloucestershire GL50 3BA (GB)

(54) COLOR LAMINATED PHOTOVOLTAIC DEVICE

(57) The present application discloses a color laminated photovoltaic device, comprising a lower-layer battery, an optical reflective layer, a series layer and an upper-layer battery. The series layer is communicated with the lower-layer battery and the upper-layer battery; the optical reflective layer is located between the lower-layer battery and the upper-layer battery, and controls, by adjusting the upper-layer battery and/or the optical reflective layer, a color presented by the color laminated photovoltaic device. According to the color laminated photovoltaic device of the present application, the optical reflective layer is inserted between the upper-layer battery and the lower-layer battery, so that the whole laminated photovoltaic device has a reflection peak at a waveband of 450-800 nm, thereby solving the problem that a color reflection peak at a visible light waveband and the spectral energy at other wavebands cannot be absorbed and utilized by the upper-layer battery, and also ensuring that the upper-layer battery of the laminated photovoltaic device has relatively high efficiency at the visible light waveband, such that the whole laminated photovoltaic device has relatively high photoelectric conversion efficiency while presenting a color.

FIG. 1

**Description**

**CROSS-REFERENCE TO RELATED APPLICATIONS**

This application claims priority to Chinese Patent Application No. 202111029107.5, entitled "COLOR LAMINATED PHOTOVOLTAIC DEVICE", filed to China National Intellectual Property Administration on September 01, 2021, which is incorporated herein by reference in its entirety.

**TECHNICAL FIELD**

The disclosure relates to the technical field of solar batteries, and in particular to a color tandem photovoltaic device.

**BACKGROUND**

Photovoltaic technology, as a very potential renewable energy technology, has attracted more and more attention and application. At present, the photovoltaic market is mainly based on crystalline silicon batteries and modules, limited by the light-trapping structure and antireflection film on the surface of crystalline silicon batteries, crystalline silicon batteries and modules usually present blue, deep blue, blue-black, or black. With the increasing number of application scenarios for photovoltaic modules and the public's increasing demand for aesthetics, traditional single-color crystalline silicon batteries and modules are difficult to meet the needs of specific markets. Color photovoltaic devices emerged at the historic moment.

A conventional solution for a color photovoltaic device is to provide an optical structure on the front surface of the device (a main light incident surface), by means such as adjusting an antireflection layer, arranging a grating, and printing a color ink, namely, arranging the optical structure on a photoelectric conversion unit (photoelectric conversion devices include a single-junction or multi-junction solar battery) of the device (according to the main light incident direction), and presenting a specific color by means of reflecting a specific waveband spectrum. The visible light band presenting colors concentrates in the waveband of 450~700 nm (excluding blue), and other colors except red are more concentrated in the waveband of 500~600 nm. Conventional color photovoltaic devices generally represent a specific color by adjusting an antireflection film on the surface of a battery to reflect a specific waveband, printing ink or using a grating and the like. When a photovoltaic device represents a specific color, it means that the device has a higher reflectivity for a corresponding visible light waveband.

In order to maximize the efficiency of a color photovoltaic device (with as little loss of efficiency as possible), a reflection peak for enabling the device to present a color should be set as narrow as possible, and the utilization of the device for the spectrum outside the reflection peak should be improved. However, the reflection peak of an optical structure usually presenting color still has a certain width (usually not less than 100 nm waveband), which greatly affects the transmittance of light in the remaining waveband. Accordingly, a conventional method for providing an optical structure on the front surface of a device to achieve color generally results in a relatively low efficiency of the device.

**SUMMARY**

In view of the above-mentioned problems, the disclosure proposes a color tandem photovoltaic device, in which an optical reflective layer is inserted between a top cell and a bottom cell, so that the whole tandem photovoltaic device has a reflection peak at a waveband of 450~800 nm. Therefore, a problem that a color reflection peak at a visible light waveband and the spectral energy at other wavebands cannot be absorbed and utilized by the top cell is solved, and it can also ensure that the top cell of the tandem photovoltaic device has relatively high efficiency at the visible light waveband, so that the whole tandem photovoltaic device has relatively high photoelectric conversion efficiency while presenting a color.

The disclosure provides a color tandem photovoltaic device, including a bottom cell, an optical reflective layer, a series connection layer, and a top cell. The series connection layer connects the bottom cell and the top cell; the optical reflective layer is located between the bottom cell and the top cell such that the color tandem photovoltaic device presents color.

Further, a waveband and reflectivity of a reflection peak of the optical reflective layer are adjusted by adjusting a structure and a material of the optical reflective layer and a band gap or a thickness of the top cell, so that the optical reflective layer has a reflection peak in a waveband of 450~800 nm and a reflectivity of the reflection peak is greater than 30%, and a color presented by the color tandem photovoltaic device is further controlled.

Further, the area of the projection of the optical reflective layer on the surface of the top cell absorption layer is not less than 80% of the surface area of the top cell absorption layer.

Further, the top cell includes a top cell absorption layer;

when the thickness of the top cell absorption layer is 200~300 nm and the optical reflective layer has a reflection peak at a waveband of 450~650 nm, the color tandem photovoltaic device has a reflection peak at a waveband of 450~650 nm; or
when the thickness of the top cell absorption layer is 300~800 nm and the optical reflective layer has a reflection peak at a waveband of 650~800 nm, the color tandem photovoltaic device has a reflection peak at a waveband of 650~800 nm.

Further, when the thickness of the top cell absorption layer is 200~300 nm, the color presented by the color tandem photovoltaic device is orange, orange-yellow, yellow, green, dark green, blue, or purple; or
when the thickness of the top cell absorption layer is 300~800 nm, the color presented by the color tandem photovoltaic device is red or brick red.

Further, the top cell includes a top cell absorption layer;
when the band gap of the top cell absorption layer is greater than or equal to the energy of the wavelength corresponding to the reflection peak, and the optical reflective layer has a reflection peak at a waveband of 650~800 nm, the color tandem photovoltaic device has a reflection peak at a waveband of 650~800 nm.

Further, the band gap of the top cell absorption layer is 1.6-3.0 ev, and the top cell absorption layer is made of a perovskite material;
the color tandem photovoltaic device presents a red or brick red color.

Further, the optical reflective layer includes at least one low refractive index layer and at least one high refractive index layer that are stacked.

Further, the refractive index of the low refractive index layer is 1.5 or less;
the refractive index of the high refractive index layer is 2.1 or more.

Further, the optical reflective layer includes n low refractive index layers and m high refractive index layers that are stacked, where n and m are integers greater than 1;
the low refractive index layer and the high refractive index layer are alternatively stacked.

Further, adjusting the structure and material of the optical reflective layer includes adjusting any one or two or more of the thickness of the low refractive index layer, the thickness of the high refractive index layer, the material of the low refractive index layer, the material of the high refractive index layer, and the stacking order of the low refractive index layer and the high refractive index layer.

Further, in the case where the thickness and the band gap of the top cell are constant values, the waveband and the reflectivity of the reflection peak of the optical reflective layer are adjusted by adjusting the thickness of the low refractive index layer, the thickness of the high refractive index layer, the material of the low refractive index layer, the material of the high refractive index layer and the stacking order of the low refractive index layer and the high refractive index layer, thereby the color presented by the color tandem photovoltaic device is controlled.

In the color tandem photovoltaic device provided in the present disclosure, the optical reflective layer is inserted between the top cell and the bottom cell, and the optical reflective layer can reflect the light in the waveband of 450~800 nm that is transmitted through the top cell and irradiates on the optical reflective layer, so that the whole tandem photovoltaic device has a reflection peak at a waveband of 450~800 nm. Therefore, a problem that a color reflection peak at a visible light waveband and the spectral energy at other wavebands cannot be absorbed and utilized by the top cell is solved, and it can also ensure that the top cell of the tandem photovoltaic device has relatively high efficiency at the visible light waveband, so that the whole tandem photovoltaic device has relatively high photoelectric conversion efficiency while presenting a color.

## BRIEF DESCRIPTION OF THE DRAWINGS

The drawings are used to provide a further understanding of the disclosure, and are not intended to limit the present disclosure in any improper manner. In the drawings:

FIG. 1 is a schematic structural diagram of a color tandem photovoltaic device provided by the disclosure;
FIG. 2 is a schematic structural diagram of a color tandem photovoltaic device provided by the disclosure;
FIG. 3 is a graph showing a relationship between a central peak position for an outward reflection of the color tandem photovoltaic device and EQE of a top cell and an bottom cell;
FIG. 4 is a graph showing a relationship between a central peak position for an outward reflection of the color tandem photovoltaic device and EQE of a top cell and an bottom cell;
FIG. 5 shows a reflectance spectrum of an optical reflective layer of Embodiment 1 provided in the disclosure;
FIG. 6 shows a reflectance spectrum of an optical reflective layer of Embodiment 2 in the related art.

FIG. 7 shows a reflectance spectrum of an optical reflective layer of Embodiment 3 provided in the disclosure;
FIG. 8 shows a reflectance spectrum of an optical reflective layer of Embodiment 4 provided in the disclosure;
FIG. 9 shows a reflectance spectrum of an optical reflective layer of Embodiment 5 in the related art.
FIG. 10 shows a reflectance spectrum of an optical reflective layer of Embodiment 6 in the related art.

Description of Reference Numerals

11 - top cell absorption layer, 12 - top cell lower functional layer, 13 - top cell upper functional layer, 21 - bottom cell absorption layer, 22 - bottom cell lower functional layer, 23 - bottom cell upper functional layer, 3 - optical reflective layer, 4 - series connection layer, 5 - upper electrode, 6 - lower electrode.

## DETAILED DESCRIPTION OF THE EMBODIMENTS

The following description of exemplary embodiments of the disclosure includes various details of the embodiments of the application to facilitate an understanding, and it should be considered exemplary only. Accordingly, those of skilled in the art will appreciate that various changes and modifications may be made to the embodiments described herein without departing from the scope and spirit of the disclosure. Also, descriptions of well-known functions and constructions are omitted from the following description for clarity and conciseness. In the disclosure, the upper and lower positions are determined according to a light incident direction, and the light incident position refers to the upper position.

In order to solve the problem of low efficiency of color devices, it is a feasible way to use tandem solar batteries with high efficiency as photoelectric conversion units. A two-terminal two-junction tandem solar battery of crystalline silicon, perovskite has the advantages of high efficiency and simple structure, and is a next generation of potential tandem photovoltaic device. However, the surface of the device is provided with an optical structure for reflecting incident light in a specific waveband to achieve color, which would result in a high loss in the efficiency of the tandem photovoltaic device. In the tandem photovoltaic device, the spectral response range of the top cell is mainly in the waveband of 400~700 nm, covering most of the visible light wavelength range. Therefore, the optical structure arranged on the front surface of the tandem device mainly affects the spectral response of the top cell, resulting in a significant decrease of the photo-generated current of the top cell. The two-terminal tandem device meets the requirement of current adaptation, and the overall current of the tandem photovoltaic device is limited by the minimum current of the subcell; therefore, arranging an optical structure on the upper surface of the tandem photovoltaic device would result in a greater loss of the overall efficiency of the tandem photovoltaic device.

Therefore, the disclosure provides a color tandem photovoltaic device, including a top cell, an optical reflective layer 3 and a bottom cell that are stacked in sequence from top to bottom. The top cell includes a top cell upper functional layer 13, a top cell absorption layer 11 and a top cell lower functional layer 12 that are stacked in sequence from top to bottom. The bottom cell includes a bottom cell upper functional layer 23, a bottom cell absorption layer 21 and a bottom cell lower functional layer 22 that are arranged in sequence from top to bottom. Namely, the color tandem photovoltaic device includes a top cell upper functional layer 13, a top cell absorption layer 11, a top cell lower functional layer 12, an optical absorption layer, a bottom cell upper functional layer 23, a bottom cell absorption layer 21 and a bottom cell lower functional layer 22 that are stacked in sequence from top to bottom.

In the disclosure, the color tandem photovoltaic device is a two-junction color tandem photovoltaic device, and the color tandem photovoltaic device further includes a series connection layer 4. The series connection layer 4 is respectively connected to the top cell and the bottom cell for connecting the top cell and the bottom cell in series, and the series connection layer 4 may be disposed at any position.

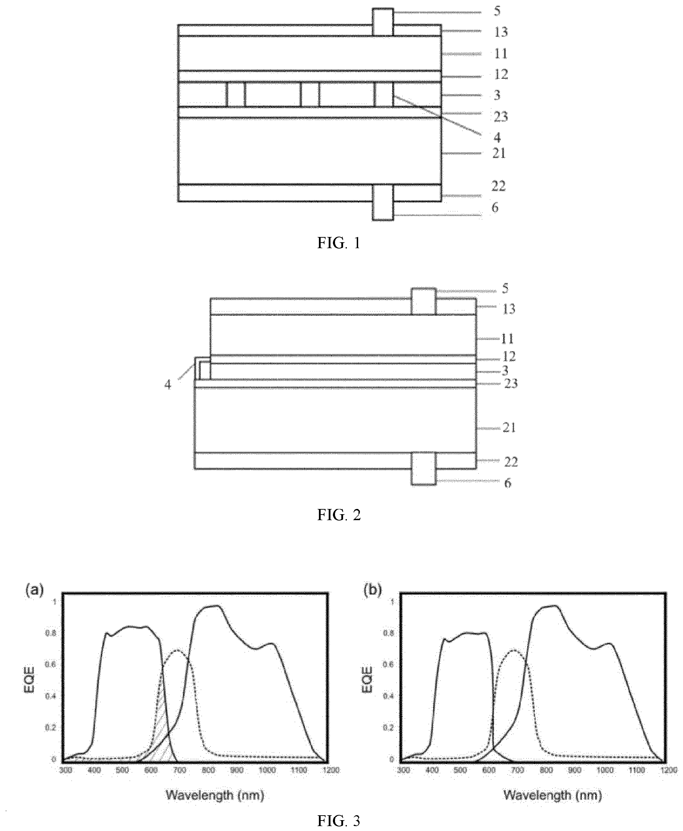

In a specific embodiment, as shown in FIG. 1, the color tandem photovoltaic device includes a top cell upper functional layer 13, a top cell absorption layer 11, a top cell lower functional layer 12, an optical reflective layer 3, a bottom cell upper functional layer 23, a bottom cell absorption layer 21, and a bottom cell lower functional layer 22, which are stacked in sequence from top to bottom. A plurality of through holes penetrating the optical reflective layer 3 are arranged in the optical reflective layer 3, the series connection layer 4 is located in the through holes, and the series connection layer 4 is respectively connected to the bottom cell upper functional layer 23 and the top cell lower functional layer 12.

In a specific embodiment, as shown in FIG. 2, the color tandem photovoltaic device includes a top cell upper functional layer 13, a top cell absorption layer 11, a top cell lower functional layer 12, an optical reflective layer 3, a bottom cell upper functional layer 23, a bottom cell absorption layer 21, and a bottom cell lower functional layer 22, that are stacked in sequence from top to bottom. The series connection layer 4 is located outside the color tandem photovoltaic device, and the series connection layer 4 is respectively connected to the bottom cell upper functional layer 23 and the top cell lower functional layer 12.

In the present disclosure, as shown above, different color tandem photovoltaic devices as shown in FIG. 1 or FIG. 2 can be formed based on different arrangements of the series connection layer 4. The materials of the series connection layer 4 used in the photovoltaic device as shown in FIG. 1 or the photovoltaic device as shown in FIG. 2 may be the same. For example, the series connection layer 4 uses a conductive material. The conductive material may be a transparent conductive semiconductor material, such as indium tin oxide (ITO), aluminum-doped zinc oxide (AZO), and may also be a metallic material, a mixed material of multiple metals, etc.

In the present disclosure, the top cell upper functional layer 13 is a multilayer stacked structure, and can play one or more functions of interface passivation, carrier selective contact and transport, and upper surface antireflection, etc. For example, the top cell upper functional layer 13 may include an antireflection layer, a transparent conductive layer, and a carrier transporting layer. The upper antireflection layer may be provided by a silicon oxynitride layer and a magnesium fluoride layer stacked. The transparent conductive layer may include but not limited to an FTO layer, an ITO layer, or an AZO layer. The carrier transporting layer may be a hole transporting layer or an electron transporting layer. The hole transporting layer may be a molybdenum oxide or a Spiro-OMeTAD layer, and the electron transporting layer may be a $SnO_2$ layer, a tin oxide layer, a C60 layer, or a C60-PCBM layer, including but not limited thereto, as long as the function in the disclosure can be achieved. The top cell lower functional layer 12 is a multilayer stacked structure and can play one or more functions such as interface passivation, carrier selective contact and transport, and lower surface antireflection. For example, the top cell lower functional layer 12 may include an antireflection layer, a transparent conductive layer, and a carrier transporting layer. The upper antireflection layer may be formed by a silicon oxynitride layer and a magnesium fluoride layer stacked. The transparent conductive layer may be an FTO layer, an ITO layer, or an AZO layer, including but not limited to these. The carrier transporting layer may be a hole transporting layer or an electron transporting layer. The hole transporting layer may be a molybdenum oxide or a Spiro-OMeTAD layer, and the electron transporting layer may be a $SnO_2$ layer, a tin oxide layer, a C60 layer, or a C60-PCBM layer, including but not limited thereto, as long as the function in the disclosure can be achieved.

In the present disclosure, the top cell upper functional layer 13 and the top cell lower functional layer 12 contact and transport different types of carriers. For example, when the top cell upper functional layer 13 conducts holes, the top cell lower functional layer 12 conducts electrons; when the top cell upper functional layer 13 conducts electrons, the top cell lower functional layer 12 conducts holes.

Specifically, the top cell absorption layer 11 is a perovskite absorption layer, and can be used to convert sunlight into electrical energy. The band gap of the top cell absorption layer 11 may be 1.6-3.0 ev, for example, 1.6 ev, 1.7 ev, 1.8 ev, 1.9 ev, 2.0 ev, 2.1 ev, 2.2 ev, 2.3 ev, 2.4 ev, 2.5 ev, 2.6 ev, 2.7 ev, 2.8 ev, 2.9 ev, and 3.0 ev.

Specifically, the material of the top cell absorption layer 11 may be an organic-inorganic hybrid perovskite material, a wide band gap perovskite such as $CsSnBr_3$ and $MaPbBr_3$, or a hybrid perovskite material.

In the present disclosure, an upper electrode 5 is disposed on the upper surface of the top cell, one end of the upper electrode 5 penetrates into the top cell upper functional layer, and the upper electrode 5 may partially or completely penetrate through the top cell upper functional layer 13. The bottom surface of the top cell is further provided with a lower electrode, one end of the lower electrode penetrates into the top cell lower functional layer, and the lower electrode may partially or completely penetrate through the top cell lower functional layer 12. The upper electrode 5 and the lower electrode may be made of metallic silver, copper, aluminum, or various metal alloys.

In the present disclosure, the bottom cell upper functional layer 23 is a multilayer stacked structure and can play one or more functions of interface passivation, carrier selective contact and transport, and upper surface antireflection, etc. For example, the bottom cell upper functional layer 23 may conduct holes or may conduct electrons. When the bottom cell upper functional layer 23 conducts holes, it is formed by an intrinsic amorphous silicon layer and a p-type amorphous silicon layer that are stacked, or formed by an intrinsic amorphous silicon layer, a p-type amorphous silicon layer, and an ITO layer that are stacked. When the bottom cell upper functional layer 23 conducts electrons, it is formed by an intrinsic amorphous silicon layer, an n-type amorphous silicon layer, and an ITO layer that are stacked.

In the present disclosure, the bottom cell lower functional layer 22 is a multilayer stacked structure and can play one or more functions of interface passivation, carrier selective contact and transport, and lower surface antireflection, etc. For example, the bottom cell lower functional layer 22 may conduct holes or may conduct electrons. When the bottom cell lower functional layer 22 conducts holes, it is formed by an intrinsic amorphous silicon layer and a p-type amorphous silicon layer that are stacked, or formed by an intrinsic amorphous silicon layer, a p-type amorphous silicon layer, and an ITO layer that are stacked. When the bottom cell lower functional layer 22 conducts electrons, it is formed by an intrinsic amorphous silicon layer, an n-type amorphous silicon layer, and an ITO layer that are stacked. The bottom cell lower functional layer 22 also includes an antireflection layer that is a silicon nitride film.

In the present disclosure, the bottom cell upper functional layer 23 and the bottom cell lower functional layer 22 contact and transport different types of carriers. For example, when the bottom cell upper functional layer 23 conducts holes, the bottom cell lower functional layer 22 conducts electrons. When the bottom cell upper functional layer 23 conducts electrons, the bottom cell lower functional layer 22 conducts holes.

Specifically, the bottom cell absorption layer 21 is a crystalline silicon absorption layer, and specifically, the crystalline silicon absorption layer may be a monocrystalline silicon absorption layer, a polycrystalline silicon absorption layer, or a microcrystalline silicon absorption layer.

In the present disclosure, an upper electrode is disposed on the upper surface of the bottom cell, one end of the upper electrode penetrates into the bottom cell upper functional layer, and the upper electrode may partially or completely penetrate through the bottom cell upper functional layer 23. The lower surface of the bottom cell is further provided with a lower electrode 6, one end of which penetrates into the bottom cell lower functional layer, and the lower electrode 6 may partially or completely penetrate through the bottom cell lower functional layer 22. The upper electrode and the lower electrode 6 may be made of metallic silver, copper, aluminum, or various metal alloys.

In the color tandem photovoltaic device provided by the present disclosure, a core feature is that the optical reflective layer 3 is arranged between the bottom cell and the top cell, and the color presented by the color tandem photovoltaic device is controlled by adjusting the structure and material of the optical reflective layer 3 and the band gap or thickness of the top cell absorption layer 11.

Specifically, by adjusting the band gap and thickness of the top cell and the structure and material of the optical reflective layer 3, the reflectivity and waveband of the reflection peak of the optical reflective layer 3 are adjusted, so that the optical reflective layer has a reflection peak in the waveband of 450~800 nm, and the reflectivity of the reflection peak is more than 30%, thereby controlling the color presented by the color tandem photovoltaic device.

In the present disclosure, the inventors of the application creatively arranged the optical reflective layer 3 between the bottom cell and the top cell, thereby solving the problem of a high loss in the efficiency of a color tandem photovoltaic device, and further enabling the photovoltaic device to present different colors well by matching the structures of the optical reflective layer 3 and the top cell.

In a specific embodiment, for example, when the band gap or the thickness of the top cell is determined to be a given value, it is possible to make a color tandem photovoltaic device have a reflection peak in the waveband of 650~800 nm. In this case, the specific waveband and reflectivity of the reflection peak of the optical reflective layer 3 can be adjusted by adjusting the structure and material of the optical reflective layer 3.

In a specific embodiment, for example, when the band gap of the top cell is determined to be 1.6-3.0 ev, it is possible to achieve a color tandem photovoltaic device having a reflection peak in the waveband of 650~800 nm. In the present disclosure, the specific waveband and reflectivity of the reflection peak of the optical reflective layer 3 can be adjusted by adjusting the structure and material of the optical reflective layer 3.

For example, when the color tandem photovoltaic device has a reflection peak in the waveband of 650~800 nm, the optical reflective layer 3 also has a reflection peak in the waveband of 650~800 nm. In this case, the band gap of the top cell is greater than or equal to the energy of the wavelength corresponding to the central peak of the reflection peak on the optical reflective layer 3 (namely, $E_g \geqslant \dfrac{1240}{\lambda}$, where $E_g$ is the band gap of the top cell and $\lambda$ is a central wavelength of the reflection peak), so that the light corresponding to the central peak position of the reflection peak is not absorbed by the upper absorption layer.

When the color tandem photovoltaic device has a reflection peak in the waveband of 650~800 nm, the color tandem photovoltaic device as a whole presents a red or brick red color, and the photoelectric conversion efficiency of the color tandem photovoltaic device is the highest. A relationship between the reflection peak central peak position of the optical reflective layer 3 and EQE (External Quantum Efficiency) of the top cell and the bottom cell of the color tandem photovoltaic device is shown in FIG. 3(a). As shown in FIG. 3(a), the reflection peak central peak position of the optical reflective layer 3 is located near the absorption edge of the top cell, and the top cell does not absorb light corresponding to the central peak position of the reflection peak; therefore, light corresponding to the central waveband of the reflection peak can transmit through the top cell to present red or brick red to the outside, and at the same time, short-wave parts other than central peak position of the reflection peak can be absorbed and used by the top cell.

In comparison with the case where the optical reflective layer 3 is disposed on the upper surface of the device, as shown in FIG. 3(b), the short-wave part of the central peak position of the reflection peak presenting color is reflected out of the device and cannot be absorbed and used by the color tandem photovoltaic device, and therefore the short-circuit current of the top cell is lower than that in FIG. 3(a), thereby limiting the entire current of the color tandem photovoltaic device, resulting in that the efficiency of the color tandem photovoltaic device as a whole is lower than that in FIG. 3(a) of the disclosure.

In another specific embodiment, for example, when the thickness of the top cell absorption layer is determined to be 300 to 800 nm, it is possible to realize a color tandem photovoltaic device having a reflection peak in a waveband of 650~800 nm. In the present disclosure, the specific waveband and reflectivity of the reflection peak of the optical reflective layer 3 can be adjusted by adjusting the structure and material of the optical reflective layer 3.

For example, when the thickness of the top cell absorption layer is determined to be 300~800 nm, the optical reflective layer 3 also has a reflection peak in the waveband of 650~800 nm, and in this case, the color tandem photovoltaic device has a reflection peak in the waveband of 650~800 nm.

In the present disclosure, when the color tandem photovoltaic device has a reflection peak in the waveband of 650~800 nm, the specific waveband and reflectivity of the reflection peak of the optical reflective layer 3 are adjusted by adjusting the structure and material of the optical reflective layer 3. Specifically, adjusting the structure and material of the optical reflective layer 3 refers to a stacked arrangement and the material of each layer. Typically, the optical reflective layer 3 includes at least one low refractive index layer and at least one high refractive index layer that are stacked.

In a specific embodiment, there may be n low refractive index layers and m high refractive index layers that are stacked, where n and m are integers greater than 1. The low refractive index layer and the high refractive index layer are alternatively stacked. m and n may or may not be equal, and when m and n are not equal, the difference between m and n is 1, i.e. $m = n \pm 1$.

In a specific embodiment, adjusting the structure and material of the optical reflective layer 3 refers to adjusting any one or two or more of: the thickness of the low refractive index layer, the thickness of the high refractive index layer, the material of the low refractive index layer, the material of the high refractive index layer, the stacking order of the low refractive index layer and the high refractive index layer.

For example, adjusting the structure and material of the optical reflective layer 3 includes: a combination of simultaneously adjusting the thickness of the low refractive index layer and the material of the low refractive index layer; a combination of simultaneously adjusting the thickness of the low refractive index layer and the thickness of the high refractive index layer; the combination of simultaneously adjusting the thickness of the low refractive index layer and the material of the high refractive index layer; a combination of simultaneously adjusting the thickness of the low refractive index layer and the stacking order of the high refractive index layer and the low refractive index layer; a combination of simultaneously adjusting the material of the low refractive index layer and the material of the high refractive index layer; a combination of simultaneously adjusting the material of the low refractive index layer and the thickness of the high refractive index layer; a combination of simultaneously adjusting the material of the low refractive index layer and the stacking order of the high refractive index layer and the low refractive index layer; a combination of simultaneously adjusting the thickness of the high refractive index layer and the material of the high refractive index layer; a combination of simultaneously adjusting the thickness of the high refractive index layer and the stacking order of the high refractive index layer and the low refractive index layer; a combination of simultaneously adjusting the material of the high refractive index layer and the stacking order of the high refractive index layer and the low refractive index layer; a combination of simultaneously adjusting the thickness of the low refractive index layer, the thickness of the high refractive index layer and the material of the low refractive index layer; a combination of simultaneously adjusting the thickness of the high refractive index layer, the material of the low refractive index layer and the material of the high refractive index layer; a combination of simultaneously adjusting the material of the low refractive index layer, the material of the high refractive index layer and the low refractive index layer and the high refractive index layer; a combination of simultaneously adjusting the thickness of the low refractive index layer, the thickness of the high refractive index layer, the material of the low refractive index layer and the material of the high refractive index layer; a combination of simultaneously adjusting the thickness of the low refractive index layer, the thickness of the high refractive index layer, the material of the low refractive index layer, the material of the high refractive index layer and the stacking order of the low refractive index layer and the high refractive index layer.

In a specific embodiment, for example, when the thickness of the top cell absorption layer 11 is determined to be a given value, it is possible to achieve a color tandem photovoltaic device having a reflection peak in the 450~650 nm waveband. At this time, the specific waveband and reflectivity of the reflection peak of the optical reflective layer 3 can be adjusted by adjusting the structure and material of the optical reflective layer 3.

In a specific embodiment, for example, when it is determined that the thickness of the top cell absorption layer 11 is 200~300 nm, it is possible to realize a color tandem photovoltaic device having a reflection peak in a waveband of 450~650 nm. In the present disclosure, the specific waveband and reflectivity of the reflection peak of the optical reflective layer 3 can be adjusted by adjusting the structure and material of the optical reflective layer 3.

For example, when the thickness of the top cell absorption layer 11 is 200~300 nm and the optical reflective layer 3 also has a reflection peak in the waveband of 450~650 nm, the color tandem photovoltaic device has a reflection peak in the waveband of 450~650 nm.

The light corresponding to the waveband having the strongest reflectivity of the optical reflective layer 3 can transmit through the top cell, then be reflected on the optical reflective layer 3, and transmit out of the color tandem photovoltaic device, so that the color tandem photovoltaic device presents the color of the waveband having the strongest reflectivity. Light corresponding to the remaining waveband is absorbed by the top cell or the bottom cell.

In the embodiment, the color tandem photovoltaic device may present a color other than red or brick red, such as orange, orange-yellow, yellow, green, dark green, blue, purple, and the like (including but not limited to these colors).

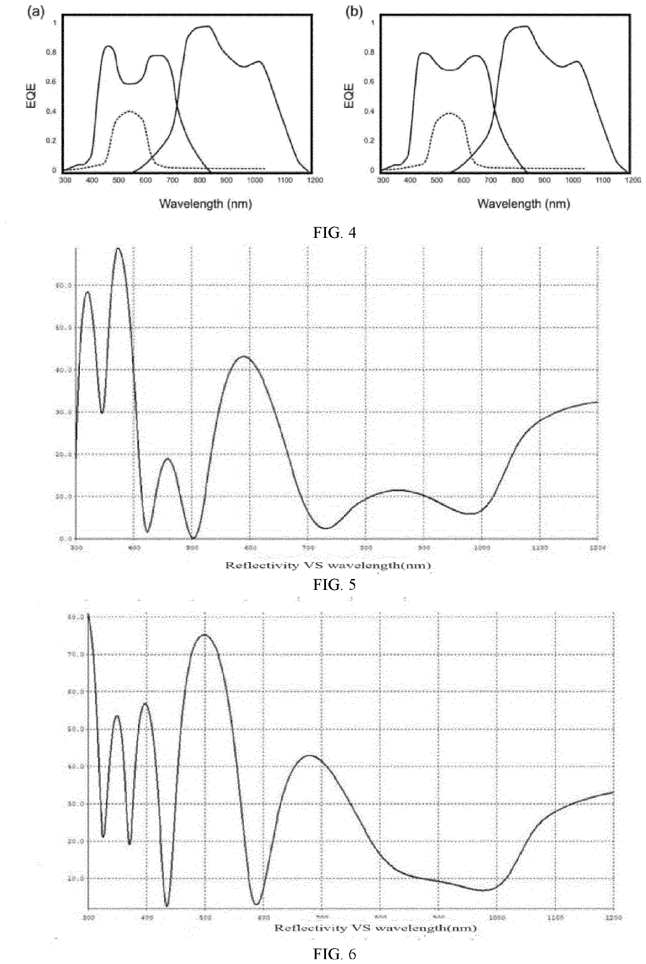

The color tandem photovoltaic device may present a color of visible light of short waveband, and the photoelectric conversion efficiency of the color tandem photovoltaic device is lower than above-mentioned tandem photovoltaic device presents red or brick red color. The relationship between the central peak position of the reflection peak of the optical reflective layer 3 and EQE of the top cell and the bottom cell of the color tandem photovoltaic device is shown in FIG. 4(a). As shown in FIG. 4(a), the top cell cannot completely absorb the energy of incident visible light in a short waveband, and in this case, light corresponding to the central peak position reflected by the optical reflective layer 3 can transmit through the top cell to present color to the outside. Specifically, incident light first passes through the top cell and is absorbed and used, EQE of the top cell and the photoelectric conversion efficiency of the color tandem photovoltaic device are ensured, so that only light in a waveband corresponding to the reflection peak of the optical reflective layer 3 can pass through the top cell, and light corresponding to the remaining waveband is used by the top cell or the bottom cell, and considering the requirements of current adaptation of the two terminal tandem devices, a higher EQE of the top cell allows the color tandem photovoltaic device to have a higher efficiency.

In comparison with the case where the optical reflective layer 3 is disposed on the upper surface of the device, as shown in FIG. 4(b), all the spectral energy reflected to the outside of the device by the optical reflective layer 3 cannot be used by the tandem photovoltaic device, and the EQE of the top cell is lower than that in FIG. 4(a); and in view of the current adaptation requirements of the two terminal tandem photovoltaic devices, the lower EQE of the top cell would result in a lower efficiency of the tandem photovoltaic device.

In the present disclosure, when the color tandem photovoltaic device has a reflection peak in the waveband of 450~650 nm, the specific waveband and reflectivity of the reflection peak of the optical reflective layer 3 are adjusted by adjusting the structure and material of the optical reflective layer 3. Specifically, adjusting the structure and material of the optical reflective layer 3 refers to adjusting the stacking arrangement and the material of each layer. Typically, the optical reflective layer 3 includes at least one low refractive index layer and at least one high refractive index layer that are stacked.

In a specific embodiment, there may be n low refractive index layers and m high refractive index layers that are stacked, wherein n and m are integers greater than 1. The low refractive index layer and the high refractive index layer are alternatively arranged.

In a specific embodiment, adjusting the structure and material of the optical reflective layer 3 refers to adjusting any one or two or more of the thickness of the low refractive index layer, the thickness of the high refractive index layer, the material of the low refractive index layer, the material of the high refractive index layer, the stacking order of the low refractive index layer and the high refractive index layer.

For example, adjusting the structure and material of the optical reflective layer 3 includes: a combination of simultaneously adjusting the thickness of the low refractive index layer and the material of the low refractive index layer; a combination of simultaneously adjusting the thickness of the low refractive index layer and the thickness of the high refractive index layer; a combination of simultaneously adjusting the thickness of the low refractive index layer and the material of the high refractive index layer; a combination of simultaneously adjusting the thickness of the low refractive index layer and the stacking order of the high refractive index layer and the low refractive index layer; a combination of simultaneously adjusting the material of the low refractive index layer and the material of the high refractive index layer; a combination of simultaneously adjusting the material of the low refractive index layer and the thickness of the high refractive index layer; a combination of simultaneously adjusting the material of the low refractive index layer and the stacking order of the high refractive index layer and the low refractive index layer; a combination of simultaneously adjusting the thickness of the high refractive index layer and the material of the high refractive index layer; a combination of simultaneously adjusting the thickness of the high refractive index layer and the stacking order of the high refractive index layer and the low refractive index layer; a combination of simultaneously adjusting the material of the high refractive index layer and the stacking order of the high refractive index layer and the low refractive index layer; a combination of simultaneously adjusting the thickness of the low refractive index layer, the thickness of the high refractive index layer and the material of the low refractive index layer; a combination of simultaneously adjusting the thickness of the high refractive index layer, the material of the low refractive index layer and the material of the high refractive index layer; a combination of simultaneously adjusting the material of the low refractive index layer and the material of the high refractive index layer and the low refractive index layer and the high refractive index layer; a combination of simultaneously adjusting the thickness of the low refractive index layer, the thickness of the high refractive index layer, the material of the low refractive index layer and the material of the high refractive index layer; a combination of simultaneously adjusting the thickness of the low refractive index layer, the thickness of the high refractive index layer, the material of the low refractive index layer, the material of the high refractive index layer and the stacking order of the low refractive index layer and the high refractive index layer.

In the present disclosure, the optical reflective layer 3 includes at least one low refractive index layer and at least one 1 high refractive index layer, and the low refractive index layer and the high refractive index layer are stacked. The refractive index of the low refractive index layer is below 1.5. The high refractive index layer has a refractive index above 2.1. refractive index as used herein refers to the average refractive index of a material in the range of 50 nm at or around the reflection peak wavelength.

Specifically, the material of the low refractive index layer may be silicon oxide, silicon oxynitride, alkali metal fluoride (e.g. sodium fluoride, lithium fluoride, etc.), alkaline earth metal fluoride (e.g. magnesium fluoride, calcium fluoride), or organic material (e.g. sprio-OMe TAD, PCBM, etc.).

Specifically, the material of the high refractive index layer may be a carbon material (e.g. C60, diamond, etc.),

a transition metal oxide (e.g. titanium oxide, molybdenum oxide, tungsten oxide, vanadium oxide, zinc oxide, etc.), a nitride (e.g. aluminum nitride, zirconium oxide, silicon nitride, aluminum oxynitride, etc.), a sulfide (e.g. tungsten sulfide, molybdenum sulfide, lead sulfide, boron carbide, silicon carbide, etc.).

Specifically, the optical reflective layer 3 includes n low refractive index layers and m high refractive index layers that are stacked, where n and m are integers greater than 1.

m and n may or may not be equal, and when m and n are not equal, the difference between m and n is 1, i.e. m = n ± 1.

The low refractive index layer and the high refractive index layer are alternatively stacked. That is to say, when the optical reflective layer 3 is a multilayer stacked structure, the optical reflective layer 3 has two types of stacking order, the first arrangement being that the low refractive index layer and the high refractive index layer are alternatively stacked in sequence, and the low refractive index layer is stacked with, and the second arrangement being that the high refractive index layer and the low refractive index layer are alternatively stacked in sequence, and the high refractive index layer is stacked with the top cell lower functional layer. Thus, in the optical reflective layer 3, depending on different types of arrangement, the color tandem photovoltaic device will present different colors.

In the present disclosure, adjusting the structure and material of the optical reflective layer includes adjusting any one or two or more of the thickness of the low refractive index layer, the thickness of the high refractive index layer, the material of the low refractive index layer, the material of the high refractive index layer, and the stacking order of the low refractive index layer and the high refractive index layer.

When the structure of the top cell has been determined (namely, the band gap and the thickness of the top cell absorption layer have been determined), the waveband and reflectivity of the reflection peak of the optical reflective layer are adjusted by adjusting the thickness of the low refractive index layer, the thickness of the high refractive index layer, the material of the low refractive index layer, the material of the high refractive index layer and the stacking order of the low refractive index layer and the high refractive index layer of the optical reflective layer 3, namely, by adjusting the thickness of the low refractive index layer, the thickness of the high refractive index layer and the material of the low refractive index layer, the material of the high refractive index layer and the stacking order of the low refractive index layer and the high refractive index layer, the waveband and reflectivity of the reflection peak of the optical reflective layer are calculated, thereby adjusting the color presented by the color tandem photovoltaic device.

Specifically, the thickness of the low refractive index layer, the thickness of the high refractive index layer, the material of the low refractive index layer, the material of the high refractive index layer and the stacking order of the low refractive index layer and the high refractive index layer, and the waveband of the reflection peak of the optical reflective layer meet the following formula (Fresnel equation):

Formula I:

$$\begin{bmatrix} A & B \\ C & D \end{bmatrix} \begin{bmatrix} cos\delta_1 & i\left(\frac{1}{\omega_1}\right)sin\delta_1 \\ i\omega_1 sin\delta_1 & cos\delta_1 \end{bmatrix} \begin{bmatrix} cos\delta_2 & i\left(\frac{1}{\omega_2}\right)sin\delta_2 \\ i\omega_2 sin\delta_2 & cos\delta_2 \end{bmatrix} \cdots \begin{bmatrix} cos\delta_m & i\left(\frac{1}{\omega_n}\right)sin\delta_m \\ i\omega_m sin\delta_m & cos\delta_m \end{bmatrix}$$

Formula II:
$$\delta_i = \frac{2\pi}{\lambda} n_i cos\phi_i$$

Formula III:
$$\omega_i = n_i cos\phi_i$$

Among them,

λ represents a wavelength of the incident light;

$\varphi_i$ represents an incident angle of the incident light in the $i^{th}$ layer structure of the optical reflective layer;

m represents the number of the low refractive index adjustment layer and the high refractive index adjustment layer in the optical reflective layer;

$n_i$ represents the refractive index of the $i^{th}$ layer structure in the optical reflective layer;

$\delta_i$ represents a phase difference of the reflected light wave of the $i^{th}$ layer structure in the optical reflective layer;

$\omega_i$ represents an angular component of the refractive index of the $i^{th}$ layer structure in the optical reflective layer in the horizontal direction;

The reflectivity of the reflection peak of the optical reflective layer meets the following formula:

$$R = \left| \frac{\omega_0 A + \omega_0 \omega_g B - C - \omega_g D}{\omega_0 A + \omega_0 \omega_g B + C + \omega_g D} \right|^2$$

Formula IV:

where $\omega_0$ represents the angular component of the refractive index of the incident structure corresponding to the optical reflective layer in the horizontal direction;

$\omega_g$ represents the angular component of the refractive index of the substrate structure corresponding to the optical reflective layer in the horizontal direction;

R represents the reflectivity of the optical reflective layer.

Specifically, when an incident light with a wavelength $\lambda$ is incident on the optical reflective layer 3 including m layers at an incident angle $\Phi_0$, firstly, $\varphi_i$ representing the incident angle of the incident light at the ith layer structure of the optical reflective layer 3 can be determined according to the incident angle $\Phi_0$, and $\delta_i$ is calculated by taking $\lambda$, $n_i$ and $\varphi_i$ into Formula II, and $\omega_i$ is calculated by taking $n_i$ and $\varphi_i$ into Formula III. The values of A, B, C, and D in the matrix are then determined by taking the calculated $\delta_i$ and $\omega_i$ into Formula I. Finally, taking A, B, C, D, and $\omega_0$ and $\omega_g$ into Formula IV, the reflectivity R of the optical reflective layer 3 having an m-layer structure for incident light of wavelength $\lambda$ can be determined.

Accordingly, according to the above-mentioned calculation process, after determining the wavelength of the incident light for which the optical reflective layer 3 is directed and the reflectivity of the optical reflective layer 3 for the incident light, the multilayer structure of the optical reflective layer 3 can be inversely calculated and designed to determine the quantity of the low refractive index layer and the high refractive index layer included in the optical reflective layer 3, the refractive indices of the low refractive index layer and the high refractive index layer. Further, after determining the refractive index possessed by the low refractive index layer, the refractive index corresponding to the low refractive index material included in the low refractive index layer and the thickness of the low refractive index layer can be determined according to the refractive index possessed by the low refractive index layer, so that the low refractive index layer constituted by the low refractive index material of the thickness has a corresponding refractive index; also, after determining the refractive index possessed by the high refractive index layer, the corresponding refractive index of the high reflectivity material included in the high refractive index layer and the thickness of the high refractive index layer may be determined according to the refractive index possessed by the high refractive index layer, so that the high refractive index layer constituted by the high refractive index material of the thickness has the corresponding refractive index.

Therefore, it can be seen from the foregoing that when the color of the color tandem photovoltaic device is set, the number of layers of the optical reflective layer 3, the thickness of each layer, and the refractive index of each layer can be calculated from the above-mentioned Formula I, Formula II and Formula III.

By the same reasoning, when the number of layers of the optical reflective layer 3, the thickness of each layer, and the refractive index of each layer have been determined, the reflection peak of the color tandem photovoltaic device can be calculated by the above-mentioned Formula I, Formula II and Formula III to determine the color presented by the color tandem photovoltaic device.

The reflectivity of the reflection peak of the optical reflective layer 3 can be calculated by Formula IV, and the greater the reflectivity, the greater the brightness of the light presented by the color tandem photovoltaic device, and the smaller the reflectivity, the less the brightness of the light presented by the color tandem photovoltaic device.

The actual calculations may be performed using corresponding simulation calculations or computer program software. A variety of commercial computing software may be employed, such as finite element simulation software, optical simulation software, etc.

Specifically, the color implementation method of the color tandem photovoltaic device is as follows: in order to make the whole of the color tandem photovoltaic device present a specific color to the outside, light of a specific waveband needs to be transmitted through a top cell to be output to the outside, and in practical cases, the reflected light of the optical reflective layer 3 is a single or multiple reflection peaks, and the reflection peaks have a certain wavelength width; setting a target peak waveband according to the target color, and if it is desired to obtain an orange tandem photovoltaic device, then the whole tandem photovoltaic device needs to obtain a reflection peak with a wavelength of 600 nm as a central wavelength to the outside; the waveband below 600 nm may have an additional reflection peak, and the relationship between the intensity of the additional reflection peak and the intensity of the target reflection peak is not limited, so that the color tandem photovoltaic device only presents the color of the target reflection peak central peak position to the outside.

In the present disclosure, the area of the projection of the optical reflective layer 3 on the surface of the top cell absorption layer 11 is not less than 80% of the surface area of the top cell absorption layer 11. Namely, in a direction perpendicular to the light incident direction, the area of the projection of the optical reflective layer 3 on the surface of the top cell absorption layer is not less than 80% of the surface area of the top cell absorption layer 11. For example, it may be 80%, 85% or 90%, etc. The larger the projected area of the optical reflective layer 3 on the surface of the top cell absorption layer 11, the more light reflected by the optical reflective layer 3, the stronger the light reflection, and the brighter the color presented by the device.

In the present disclosure. The optical reflective layer 3 does not function as an electrical connection, and therefore the material of the optical reflective layer 3 is not limited on whether the material can conduct electricity.

In the present disclosure, the reflection peak of the optical reflective layer 3 corresponds to red light when being at 770~622 nm, the reflection peak of the optical reflective layer 3 corresponds to orange light when being at 622~597 nm, the reflection peak of the optical reflective layer 3 corresponds to yellow light when being at 597~577 nm, the reflection peak of the optical reflective layer 3 corresponds to green light when being at 577~492 nm, and the reflection peak of the optical reflective layer 3 corresponds to blue light when being at 492~450 nm.

Embodiments

The experimental methods used in the following embodiments are conventional unless otherwise specified.

The materials, reagents, and the like used in the following embodiments are commercially available unless otherwise specified.

Embodiment 1

As shown in FIG. 1, the reflection waveband of the color tandem photovoltaic device of this embodiment was 450~650 nm, and the color tandem photovoltaic device includes a top cell, an optical reflective layer 3 and a bottom cell, that are stacked in sequence from top to bottom. The top cell includes a top cell upper functional layer 13, a top cell absorption layer 11 and a top cell lower functional layer 12, that are stacked in sequence from top to bottom. The bottom cell includes a bottom cell upper functional layer 23, a bottom cell absorption layer 21 and a bottom cell lower functional layer 22, that are stacked in sequence from top to bottom. A plurality of through holes penetrating the optical reflective layer 3 are disposed in the optical reflective layer 3, a series connection layer 4 is located in the through holes, and the series connection layer 4 connects the bottom cell upper functional layer 23 and the top cell lower functional layer 12 in series.

The top cell was a perovskite cell with a wide band gap, the band gap width of the top cell was 1.7 ev; the top cell absorption layer 11 is a perovskite absorption layer, the material of the perovskite absorption layer is an organic-inorganic hybrid perovskite material, and the thickness of the top cell absorption layer 11 is 250 nm.

The top cell upper functional layer 13 includes an upper antireflection layer, a transparent conductive layer and a carrier transporting layer that are stacked. The upper antireflection layer is formed by a silicon oxynitride layer and a magnesium fluoride layer that are stacked; the carrier transporting layer is a hole transporting layer, namely, a molybdenum oxide layer and the thickness thereof is 20 nm; and the transparent conductive layer is an ITO layer and the thickness thereof is 60 nm.

The top cell lower functional layer 12 includes a carrier transporting layer that is an electron transporting layer, namely, the carrier transporting layer is formed by a C60 layer and a tin oxide layer that are stacked, the thickness of the C60 layer is 20 nm, and the thickness of the tin oxide layer is 30 nm.

An upper electrode is disposed on an upper surface of the top cell, and a lower electrode is disposed on a lower surface of the top cell (not shown in FIG. 1).

The bottom cell is a crystalline silicon-amorphous silicon heterojunction solar cell, and both the upper and lower surfaces of the bottom cell have a textured surface, and the bottom cell absorption layer 21 is an n-type silicon wafer.

The bottom cell upper functional layer 23 may conduct holes, which is formed by an intrinsic amorphous silicon layer and a p-type amorphous silicon layer that are stacked.

The bottom cell lower functional layer 22 could conduct electrons, which is formed by an intrinsic amorphous silicon layer, an n-type amorphous silicon layer, an ITO layer, and a silicon nitride film that are stacked.

An upper electrode (not shown in FIG. 1) is disposed on the upper surface of the bottom cell, and a lower electrode is disposed on the lower surface of the bottom cell.

The optical reflective layer 3 includes a first high refractive index layer, a first low refractive index layer, a second high refractive index layer, and a second low refractive index layer that are stacked in sequence from top to bottom. The first high refractive index layer is a titanium oxide layer with a thickness of 160 nm, the first low refractive index layer is a magnesium fluoride layer with a thickness of 32 nm, the second high refractive index layer is a titanium oxide layer with a thickness of 240 nm, and the second low refractive index layer is a magnesium fluoride layer with a thickness of 32 nm.

The reflection effect of the optical reflective layer 3 is as shown in FIG. 5. As shown in FIG.5, light of a short wave below 400 nm is absorbed by the top cell, the optical reflective layer 3 has the strongest central reflection peak at 600 nm (the 600 nm waveband corresponds to orange-yellow light), the reflectivity of the central reflection peak is 43%, and the color tandem photovoltaic device presents an orange-yellow color.

Embodiment 2

The difference between Embodiment 2 and Embodiment 1 lies in the optical reflective layer 3. The optical reflective layer 3 in Embodiment 2 includes a first high refractive index layer, a first low refractive index layer, a second high refractive index layer, and a second low refractive index layer that are stacked in sequence from top to bottom. The first high refractive index layer is a titanium oxide layer with a thickness of 120 nm, the first low refractive index layer is a magnesium fluoride layer with a thickness of 70 nm, the second high refractive index layer is a titanium oxide layer with a thickness of 280 nm, and the second low refractive index layer is a magnesium fluoride layer with a thickness of 60 nm.

The reflection effect of the optical reflective layer 3 is shown in FIG. 6. As shown in FIG.6, short-wave light below 400 nm is absorbed by the top cell; the optical reflective layer 3 has the strongest central reflection peak at 500 nm (a waveband of 500 nm corresponds to green light), and the reflectivity of the central reflection peak is 75%; however, the reflection peak at 700 nm (a waveband of 700 nm corresponds to red light) will have a certain effect on the color of the color tandem photovoltaic device, and the intensity of the reflection peak at 500 nm is twice the intensity of the reflection peak at 700 nm; therefore, the final color of the color tandem photovoltaic device is mainly green, and comprehensively presents dark green.

Embodiment 3

The difference between Embodiment 3 and Embodiment 1 lies in the optical reflective layer 3. The optical reflective layer 3 in embodiment 3 includes a first high refractive index layer, a first low refractive index layer, a second high refractive index layer, a second low refractive index layer, a third high refractive index layer and a third low refractive index layer stacked in sequence from top to bottom, where the first high refractive index layer is a titanium oxide layer with a thickness of 45 nm, the first low refractive index layer is a magnesium fluoride layer with a thickness of 40 nm, the second high refractive index layer is a titanium oxide layer with a thickness of 34 nm, and the second low refractive index layer is a magnesium fluoride layer with a thickness of 279 nm, the third high refractive index layer is a titanium oxide layer with a thickness of 45 nm, and the third low refractive index layer is a magnesium fluoride layer with a thickness of 18 nm.

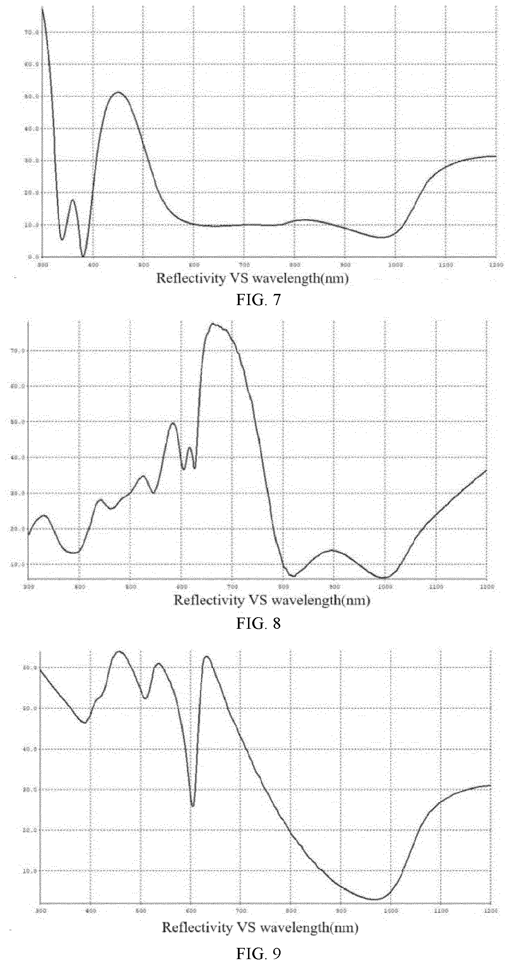

The reflection effect of the optical reflective layer 3 is shown in FIG. 7. As shown in FIG. 7, light of a short wave below 400 nm is absorbed by the top cell, the optical reflective layer 3 has the strongest central reflection peak at 450 nm (a waveband of 450nm corresponds to blue light), the reflectivity of the central reflection peak is 51%, and the color tandem photovoltaic device presents a blue color.

Embodiment 4

The reflection waveband of the color tandem photovoltaic device of this embodiment is 650~800 nm, and the color tandem photovoltaic device includes a top cell, an optical reflective layer 3, and a bottom cell, that are stacked in sequence from top to bottom, where the top cell includes a top cell upper functional layer 13, a top cell absorption layer 11 and a top cell lower functional layer 12 that are stacked in sequence from top to bottom, and the bottom cell includes a bottom cell upper functional layer 23, a bottom cell absorption layer 21 and a bottom cell lower functional layer 22 that are stacked in sequence from top to bottom. A plurality of through holes penetrating the optical reflective layer 3 are arranged in the optical reflective layer 3, a series connection layer 4 is located in the through holes, and the series connection layer 4 connects the bottom cell upper functional layer 23 and the top cell lower functional layer 12 in series.

The top cell is a perovskite cell with a wide band gap, the band gap width of the top cell is 1.9 ev, the top cell absorption layer 11 is a perovskite absorption layer, the material of the perovskite absorption layer is $CsSnBr_3$, and the thickness of the top cell absorption layer 11 is 300 nm.

The upper functional layer 13 includes an upper antireflection layer, a transparent conductive layer and a carrier transporting layer that are stacked, where the upper antireflection layer is formed by a silicon nitride layer and a magnesium fluoride layer that are stacked; the carrier transporting layer is a hole transporting layer, namely, a Spiro-OMeTAD layer with a thickness of 20 nm, and the transparent conductive layer is an ITO layer with a thickness 60 nm.

The top cell lower functional layer 12 includes a carrier transporting layer and a transparent conductive layer, where the carrier transporting layer is an electron transporting layer, namely, a C60-PCBM layer with a thickness of 30 nm, and the transparent conductive layer is an ITO layer with a thickness of 70 nm.

An upper electrode is disposed on an upper surface of the top cell, and a lower electrode is disposed on a lower surface of the top cell (not shown in FIG. 1). The upper electrode is in contact with the ITO layer in the top cell upper functional layer 13, and the lower electrode is in contact with the ITO layer in the top cell lower functional layer 12.

The bottom cell is a heterogeneous crystalline silicon battery, and both the upper and lower surfaces of the bottom cell have a textured surface, and the bottom cell absorption layer 21 is an n-type silicon wafer.

The bottom cell upper functional layer 23 can conduct holes, i.e. formed by an intrinsic amorphous silicon layer, a p-type amorphous silicon layer, and an ITO layer that are stacked.

The bottom cell lower functional layer 22 can conduct electrons, i.e. is formed by an intrinsic amorphous silicon layer, an n-type amorphous silicon layer, an ITO layer, and a silicon nitride film that are stacked.

An upper electrode (not shown in FIG. 1) is disposed on the upper surface of the bottom cell, and a lower electrode is disposed on the lower surface of the bottom cell, the upper electrode being in contact with the ITO layer in the bottom cell upper functional layer 23, and the lower electrode being in contact with the ITO layer in the bottom cell lower functional layer 22.

The optical reflective layer 3 includes a first low refractive index layer, a first high refractive index layer, a second low refractive index layer, a second high refractive index layer, a third low refractive index layer, and a third high refractive index layer that are stacked in sequence from top to bottom, where the first low refractive index layer is a magnesium fluoride layer with a thickness of 90 nm, the first high refractive index layer is a tungsten sulfide layer with a thickness of 17 nm, the second low refractive index layer is a magnesium fluoride layer with a thickness of 90 nm, the second high refractive index layer is a tungsten sulfide layer with a thickness of 65 nm, and the third low refractive index layer is a magnesium fluoride layer with a thickness of 14 nm and the third high refractive index layer is a tungsten sulfide layer with a thickness of 50 nm.

The reflection effect of the optical reflective layer 3 is shown in FIG. 8. As shown in FIG. 8, light of a short wave below 600 nm is absorbed by the top cell, the optical reflective layer 3 has the strongest central reflection peak at 680 nm (the 680 nm waveband corresponds to light of a dark red), and the reflectivity of the central reflection peak at 680 nm is 75%, and the color tandem photovoltaic device presents a dark red.

Embodiment 5

The difference between Embodiment 5 and Embodiment 4 lies in the optical reflective layer 3. The optical reflective layer 3 in Embodiment 5 includes a first low refractive index layer and a first high refractive index layer that are stacked in sequence from top to bottom, where the first low refractive index layer is a magnesium fluoride layer with a thickness of 80 nm, and the first high refractive index layer is a tungsten sulfide layer with a thickness of 12 nm.

The reflection effect of the optical reflective layer 3 is shown in FIG. 9. As shown in FIG.9, light of a short wave below 600 nm is absorbed by the top cell, the optical reflective layer 3 has the strongest central reflection peak at 640 nm (the 640 nm waveband corresponds to red light), and the reflectivity of the central reflection peak at 640 nm is 64%, and the color tandem photovoltaic device represents red.

Embodiment 6

The difference between Embodiment 6 and Embodiment 5 lies in the optical reflective layer 3. The optical reflective layer 3 in Embodiment 6 includes a first high refractive index layer and a first low refractive index layer stacked in sequence from top to bottom, where the first low refractive index layer is a magnesium fluoride layer with a thickness of 80 nm, and the first high refractive index layer is a tungsten sulfide layer with a thickness of 12 nm.

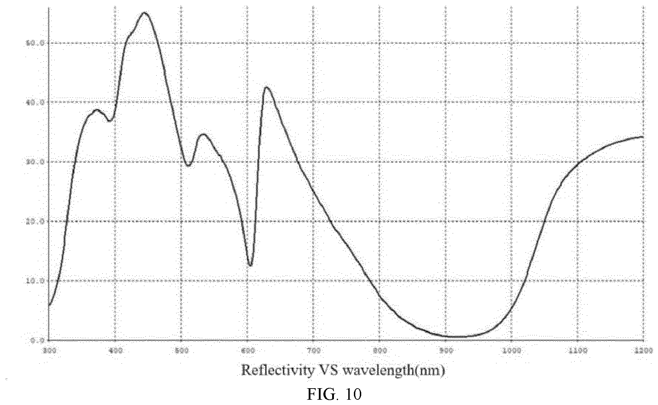

The reflection effect of the optical reflective layer 3 is shown in FIG. 10. As shown in FIG. 10, The reflectivity of the central reflection peak at 630 nm is 42.8%. Changing the order of stacking layers of the reflective layer has little effect on the position of the central peak position, but significantly affects the intensity of the reflection peak.

Table 1

| | | Embodiment 1 | Embodiment 2 | Embodiment 3 | Embodiment 4 | Embodiment 5 | Embodiment 6 |
|---|---|---|---|---|---|---|---|
| Top cell absorption layer | Band gap/ev | 1.7 | 1.7 | 1.7 | 1.9 | 1.9 | 1.9 |
| | Thickness /nm | 250 | 250 | 250 | 300 | 300 | 300 |
| Optical reflective layer | First low refractive index layer | Magnesium fluoride layer/ Thickness 32 nm | Magnesium fluoride layer/ Thickness 70 nm | Magnesium fluoride layer/ Thickness 40 nm | Magnesium fluoride layer/ Thickness 90 nm | Magnesium fluoride layer/ Thickness 80 nm | Magnesium fluoride layer/ Thickness 80 nm |
| | First high refractive index layer | Titanium oxide layer/ Thickness 32 nm | Titanium oxide layer/ Thickness 120 nm | Titanium oxide layer/ Thickness 45 nm | Tungsten sulfide layer/ Thickness 17 nm | Tungsten sulfide layer/ Thickness 12 nm | Tungsten sulfide layer/ Thickness 12 nm |
| | Second low refractive index layer | Magnesium fluoride layer/ Thickness 32 nm | Magnesium fluoride layer/ Thickness 60 nm | Magnesium fluoride layer/ Thickness 279 nm | Magnesium fluoride layer/ Thickness 90 nm | -- | -- |
| | Second high refractive index layer | Titanium oxide layer/ Thickness 240 nm | Titanium oxide layer/ Thickness 280 nm | Titanium oxide layer/ Thickness 34 nm | Tungsten sulfide layer/ Thickness 65 nm | -- | -- |
| | Third low refractive index layer | - | - | Magnesium fluoride layer/ Thickness 18 nm | Magnesium fluoride layer/ Thickness 14 nm | -- | -- |
| | Third high refractive index layer | - | - | Titanium oxide layer/ Thickness 45 nm | Tungsten sulfide layer/ Thickness 50 nm | -- | -- |
| Central reflection peak | Wavelength/nm | 600 | 500 | 450 | 680 | 640 | 630 |
| | reflectivity/% | 43 | 75 | 51 | 75 | 64 | 42.8 |
| Presented color | | Orange-yellow | Dark green | Blue | Dark red | Red | Red |

Although described in connection with the embodiments of the disclosure, the disclosure is not limited to the specific embodiments and fields of application described above, which are intended to be illustrative, instructive, and not limiting. Those skilled in the art, with the inspiration from the present description and without departing from the scope of the claims of the disclosure, can also make a great variety of forms, all of which fall within the scope of the disclosure.

**Claims**

1. A color tandem photovoltaic device, comprising a bottom cell, an optical reflective layer, a series connection layer, and a top cell, wherein the series connection layer connects the bottom cell and the top cell; the optical reflective layer is located between the bottom cell and the top cell such that the color tandem photovoltaic device presents color.

2. The color tandem photovoltaic device according to claim 1, wherein a waveband and reflectivity of a reflection peak of the optical reflective layer are adjusted by adjusting a structure and a material of the optical reflective layer and a band gap or a thickness of the top cell, so that the optical reflective layer has a reflection peak in a waveband of 450~800 nm and a reflectivity of the reflection peak is greater than 30%, and a color presented by the color tandem photovoltaic device is further controlled.

3. The color tandem photovoltaic device according to claim 2, wherein

   the top cell comprises a top cell absorption layer;
   when the thickness of the top cell absorption layer is 200~300 nm and the optical reflective layer has a reflection peak at a waveband of 450~650 nm, the color tandem photovoltaic device has a reflection peak at a waveband of 450~650 nm; or
   when the thickness of the top cell absorption layer is 300~80 nm and the optical reflective layer has a reflection peak at a waveband of 650~800 nm, the color tandem photovoltaic device has a reflection peak at a waveband of 650~800 nm.

4. The color tandem photovoltaic device according to claim 3, wherein when the thickness of the top cell absorption layer is 200~300 nm, the color presented by the color tandem photovoltaic device is orange, orange-yellow, yellow, green, dark green, blue, or purple; or
   when the thickness of the top cell absorption layer is 300~800 nm, the color presented by the color tandem photovoltaic device is red or brick red.

5. The color tandem photovoltaic device according to claim 2, wherein

   the top cell comprises a top cell absorption layer;
   when the band gap of the top cell absorption layer is greater than or equal to energy of the wavelength corresponding to the reflection peak, and the optical reflective layer has a reflection peak at a waveband of 650~800 nm, the color tandem photovoltaic device has a reflection peak at a waveband of 650~800 nm.

6. The color tandem photovoltaic device according to claim 5, wherein

   the band gap of the top cell absorption layer is 1.6-3.0 ev, and the top cell absorption layer is made of a perovskite material;
   the color tandem photovoltaic device presents a red or brick red color.

7. The color tandem photovoltaic device according to any one of claims 3 to 6, wherein an area of a projection of the optical reflective layer on a surface of the top cell absorption layer is not less than 80% of the area of the surface of the top cell absorption layer.

8. The color tandem photovoltaic device according to any one of claims 1 to 7, wherein the optical reflective layer comprises at least one low refractive index layer and at least one high refractive index layer that are stacked.

9. The color tandem photovoltaic device according to claim 8, wherein

   a refractive index of the low refractive index layer is below 1.5; and

the refractive index of the high refractive index layer is above 2.1.

10. The color tandem photovoltaic device according to claim 8, wherein

the optical reflective layer comprises n low refractive index layers and m high refractive index layers that are stacked, wherein n and m are integers greater than 1;
the low refractive index layers and the high refractive index layers are alternatively stacked.

11. The color tandem photovoltaic device according to any one of claims 9 and 10, wherein the adjusting the structure and the material of the optical reflective layer comprises adjusting any one or two or more of the thickness of the low refractive index layer, the thickness of the high refractive index layer, the material of the low refractive index layer, the material of the high refractive index layer, and a stacking order of the low refractive index layer and the high refractive index layer.

12. The color tandem photovoltaic device according to claim 11, wherein when the thickness and the band gap of the top cell are constant values, the waveband and the reflectivity of the reflection peak of the optical reflective layer are adjusted by adjusting the thickness of the low refractive index layer, the thickness of the high refractive index layer, the material of the low refractive index layer, the material of the high refractive index layer and the stacking order of the low refractive index layer and the high refractive index layer, so that the color presented by the color tandem photovoltaic device is controlled.

FIG. 1

FIG. 2

FIG. 3

EP 4 379 818 A1

FIG. 4

FIG. 5

FIG. 6

18

Reflectivity VS wavelength(nm)

FIG. 7

Reflectivity VS wavelength(nm)

FIG. 8

Reflectivity VS wavelength(nm)

FIG. 9

Reflectivity VS wavelength(nm)

FIG. 10

## INTERNATIONAL SEARCH REPORT

| | International application No. |
|---|---|
| | **PCT/CN2022/095202** |

**A.    CLASSIFICATION OF SUBJECT MATTER**

H01L 31/0725(2012.01)i;   H01L 31/0216(2014.01)i;   H01L 31/0747(2012.01)i;   H01L 51/50(2006.01)i

According to International Patent Classification (IPC) or to both national classification and IPC

**B.    FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

VEN; CNABS; CNTXT; USTXT; EPTXT; WOTXT; CNKI: 彩色, 颜色, 光伏, 太阳能电池, 幕墙, 双面, 双层, 串联, 反射层, 中间, 中部, colour, photovoltaic, solar cell, reflection, double layer, double-sided

**C.    DOCUMENTS CONSIDERED TO BE RELEVANT**

| Category* | Citation of document, with indication, where appropriate, of the relevant passages | Relevant to claim No. |
|---|---|---|
| X | CN 102651362 A (KISCO) 29 August 2012 (2012-08-29)<br>description, paragraphs [0034]-[0066], and figures 1-8c | 1-12 |
| X | CN 101286531 A (DELTA ELECTRONICS INC.) 15 October 2008 (2008-10-15)<br>description, page 4, line 19-page 7, line 11, and figures 3 and 4 | 1-12 |
| A | CN 111653640 A (KUNSHAN FUSHITONG AUTOMATION EQUIPMENT CO., LTD.) 11 September 2020 (2020-09-11)<br>entire document | 1-12 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **15 July 2022** | **27 July 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/095202**

| Patent document cited in search report | | | Publication date (day/month/year) | Patent family member(s) | | | Publication date (day/month/year) |
|---|---|---|---|---|---|---|---|
| CN | 102651362 | A | 29 August 2012 | KR | 20120097651 | A | 05 September 2012 |
| | | | | KR | 101203452 | B1 | 21 November 2012 |
| | | | | IN | 201102824 | I4 | 21 June 2013 |
| | | | | CN | 102651362 | B | 21 January 2015 |
| CN | 101286531 | A | 15 October 2008 | None | | | |
| CN | 111653640 | A | 11 September 2020 | CN | 212230443 | U | 25 December 2020 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111029107